Europäisches Patentamt

**European Patent Office**

Office européen des brevets

(11) Veröffentlichungsnummer: **0 226 741**
**B1**

(12) **EUROPÄISCHE PATENTSCHRIFT**

(45) Veröffentlichungstag der Patentschrift:
02.08.89

(51) Int. Cl.⁴: **G03F 7/16, G03F 7/26**

(21) Anmeldenummer: **86114303.0**

(22) Anmeldetag: **16.10.86**

(54) Verfahren zur Herstellung eines positiv arbeitenden Photoresists.

(30) Priorität: **25.10.85 US 791252**

(43) Veröffentlichungstag der Anmeldung:
**01.07.87 Patentblatt 87/27**

(45) Bekanntmachung des Hinweises auf die Patenterteilung:
**02.08.89 Patentblatt 89/31**

(84) Benannte Vertragsstaaten:
**AT CH DE FR GB IT LI NL**

(73) Patentinhaber: **HOECHST CELANESE CORPORATION,**
**Route 202-206 North, Somerville, N.J. 08876(US)**

(72) Erfinder: **Pampalone, Thomas R., 42 Essex Drive,**
**Mendham New Jersey 07945(US)**

(74) Vertreter: **Euler, Kurt Emil, Dr. et al, HOECHST AG - Werk**
**KALLE Patentabteilung**
**Postfach 3540 Rheingaustrasse 190,**
**D-6200 Wiesbaden(DE)**

(56) Entgegenhaltungen:
EP-A- 0 021 719
EP-A- 0 053 708
EP-A- 0 114 126
EP-A- 0 164 248
EP-A- 0 164 620
EP-A- 0 178 594
EP-A- 0 195 315
EP-A- 0 212 482
DE-A- 3 305 923
US-A- 3 666 473

PHOTOGRAPHIC SCIENCE AND ENGINEERING, vol. 21,
no. 5, September/October 1977, pages 290-292, Society
of Photographic Scientists and Engineers, Washington,
D.C., US; K. JINNO et al.: "Baking characteristics of
positive photoresists"

(56) Entgegenhaltungen: (Fortsetzung)
SOLID STATE TECHNOLOGY, vol. 26, no. 8,
August 1983, pages 211-217, Port Washington, New
York, US; T. BATCHELDER et al.: "Bake effects in
positive photoresist"
PATENT ABSTRACTS OF JAPAN, vol. 9,
no. 310 (E-364)[2033], 6th December 1985; &
JP-A-60 145 616 (FUJITSU K.K.) 01-08-1985
IBM TECHNICAL DISCLOSURE BULLETIN, vol. 13, no. 2,
July 1970, page 530, New York, US; L.H. KAPLAN:
"Exposure time reduction for positive photoresists"
Paint and Resin, Band 53, Nr. 5, Oktober 1983, S. 42-47

EP 0 226 741 B1

## Beschreibung

Die vorliegende Erfindung betrifft ein Verfahren zur Herstellung eines Photoresists durch Beschichten eines Schichtträgers mit einer strahlungsempfindlichen Beschichtungslösung aus mindestens einem wasserunlöslichen, in wäßrig-alkalischen Lösungen löslichen Bindemittel und mindestens einer strahlungsempfindlichen Verbindung, wie ein oChinondiazid, in einem Lösungsmittel, das Propylenglykolalkyletheracetat enthält oder daraus besteht, Vortrocknen der Beschichtungslösung bei erhöhter Temperatur, bildmäßiges Belichten der gebildeten Schicht mit aktinischer Strahlung, Entwickeln durch Weglösen der belichteten Bereiche mit einem wäßrig-alkalischen Entwickler und Nacherwärmen zwecks Verfestigung der Bildschicht.

Die Herstellung von positiv-arbeitenden Photoresistansätzen ist bekannt und wird zum Beispiel in US-A 3,666,473, US-A 4,115,128 und US-A 4,173,470 beschrieben. Dabei handelt es sich um alkalilösliche Phenolformaldehyd-Novolakharze in Verbindung mit lichtempfindlichen Stoffen, gewöhnlich substituierten Naphthochinondiazidverbindungen. Die Harze und lichtempfindlichen Stoffe werden in einem organischen Lösemittel oder Lösemittelgemisch gelöst und als dünne Schicht bzw. Beschichtung auf einen für den vorgesehenen Verwendungszweck geeigneten Schichtträger aufgebracht.

Die Novolakharzkomponente dieser Photoresistansätze ist in wäßrig-alkalischen Lösungen löslich, wobei aber die lichtempfindliche Naphthochinondiazidverbindung als Inhibitor auf das Harz wirkt. Wenn jedoch bestimmte Bereiche des beschichteten Trägers mit aktinischer Strahlung belichtet werden, erfährt die lichtempfindliche Verbindung eine durch die Bestrahlung induzierte strukturelle Umwandlung, und die belichteten Bereiche der Beschichtung werden löslicher als die unbelichteten. Durch diesen Löslichkeitsunterschied lösen sich die belichteten Bereiche der Photoresistschicht beim Eintauchen des Schichtträgers in eine alkalische Entwicklerlösung, während die unbelichteten Bereiche weitgehend unbeeinträchtigt bleiben, so daß auf dem Schichtträger ein positives Reliefbild entsteht.

In den meisten Fällen wird der entwickelte Schichtträger mit einer Ätzlösung oder Gasplasma behandelt. Dabei schützt die Photoresistschicht die beschichteten Bereiche des Trägers vor dem Ätzmittel, so daß dieses nur die unbeschichteten Bereiche ätzen kann. Das sind bei einem positiv arbeitenden Resist die mit aktinischer Strahlung belichteten Bereiche. Es kann also auf dem Schichtträger ein Ätzmuster entsprechend dem Bild der Maske, Schablone usw. erzeugt werden, die vor dem Entwickeln zur Herstellung bestimmter Belichtungsmuster verwendet wurde.

Das nach dem oben beschriebenen Verfahren hergestellte Reliefbild aus Photoresist auf dem Schichtträger eignet sich für verschiedene Anwendungszwecke, zum Beispiel als Maske oder Bild, beispielsweise bei der Herstellung von Halbleiterbauelementen in der Mikroelektronik.

Für die produktionstechnische Nutzung eines Photoresists wichtige Eigenschaften sind die folgenden: Lichtempfindlichkeit, Entwicklungskontrast, Bildauflösung und Haftung auf dem Schichtträger.

Eine erhöhte Lichtempfindlichkeit ist wichtig für einen Photoresist, insbesondere wenn er für Anwendungen eingesetzt wird, bei denen mehrere Belichtungen erforderlich sind, z.B. bei der Erzeugung von Mehrfachbildern durch ein Wiederholungsverfahren oder in Fällen, in denen Licht mit abgeschwächter Intensität verwendet wird, z.B. in der Projektionsbelichtungstechnik, bei der das Licht eine Reihe von Objektiven und monochromatischen Filtern durchläuft. Eine erhöhte Lichtempfindlichkeit ist also ganz besonders wichtig für ein Resistgemisch, das in Verfahren eingesetzt wird, bei denen Mehrfachbelichtungen durchgeführt werden müssen, um eine Maske oder eine Serie von Schaltbildern auf einem Schichtträger zu erzeugen. Optimale Bedingungen ergeben sich durch eine gleichbleibende Entwicklungstemperatur und -zeit bei einer bestimmten Entwicklungsart sowie durch ein Entwicklersystem, das so ausgewählt ist, daß ein vollständiges Ausentwickeln der belichteten Resistbereiche erreicht und gleichzeitig der Dickenverlust der unbelichteten Resistbereiche bei höchstens etwa 10 % der anfänglichen Dicke gehalten wird.

Unter Entwicklungskontrast ist der Unterschied zwischen dem Prozentanteil des Schichtverlusts in den belichteten Bereichen nach dem Entwickeln und dem Prozentanteil des Schichtverlusts in den unbelichteten Bereichen zu verste hen. Normalerweise wird ein mit einem belichteten Resist beschichteter Träger so lange entwickelt, bis die Schicht sich in den belichtetenen Bereichen im wesentlichen vollständig abgelöst hat. Der Entwicklungskontrast kann daher dadurch bestimmt werden, daß nach dem vollständigen Ablösen der belichteten Schichtbereiche einfach der Prozentanteil des Schichtverlusts in den unbelichteten Bereichen gemessen wird.

Unter Bildauflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, mit einem hohen Grad an Flankensteilheit des Bildes in den ausentwickelten belichteten Zwischenräumen.

Für viele technische Anwendungen, insbesondere für die Herstellung von Halbleiterbauelementen in der Mikroelektronik, muß ein Photoresist einen hohen Auflösungsgrad aufweisen, wenn er sehr kleine Linien- und Zwischenraumbreiten (in der Größenordnung von 1 μm) wiedergeben soll.

Die Fähigkeit eines Resists zur Wiedergabe sehr kleiner Abmessungen in der Größenordnung von 1 μm und darunter ist bei der Herstellung von VLSI-Schaltungen auf Siliziumchips und ähnlichen Komponenten von größter Bedeutung. Die Schaltungsdichte auf einem solchen Chip kann nur durch eine Steigerung des Auflösungsvermögens des Resists - vorausgesetzt, es wird mit photolithographischen Verfahren gearbeitet - erhöht werden. Obwohl negativ arbeitende Photoresists, bei denen die belichteten Bereiche der Resistschicht im Entwickler unlöslich sind und die unbelichteten Bereiche vom Entwickler abgelöst werden, in der Halbleiterindustrie in großem Umfang für diesen Zweck verwendet werden, haben doch die positiv-arbeitenden Photoresists von ihrer Natur her eine höhere Bildauflösung und werden als Ersatz für die negativ-arbeitenden Resists eingesetzt.

Beim Einsatz von herkömmlichen positiv-arbeitenden Photoresists für die Herstellung von Halbleiterbauelementen in der Mikroelektronik besteht die Schwierigkeit, daß die positiv-arbeitenden Resists im allgemeinen eine geringere Lichtempfindlichkeit haben als die negativ-arbeitenden Resists.

In der Vergangenheit wurden bereits verschiedene Versuche unternommen, um die Lichtempfindlichkeit positiv-arbeitender Photoresistgemische zu verbessern. In US-A 3,666,473 wird zum Beispiel ein Gemisch aus zwei Phenolformaldehyd-Novolaken zusammen mit einer üblichen lichtempfindlichen Verbindung verwendet, wobei diese Novolakharze durch ihre Lösungsgeschwindigkeit in alkalischen Lösungen eines bestimmten pH-Werts und durch ihren Trübungspunkt definiert sind.

In US-A 4,115,128 wird zur Steigerung der Lichtempfindlichkeit dem Phenolharz und dem als lichtempfindliche Verbindung verwendeten Naphthochinondiazid eine dritte Komponente, nämlich ein zyklisches Anhydrid einer organischen Säure, hinzugefügt.

K. Jinno et al. beschreiben in «Photographic Science and Engineering, Vol. 21, No. 5, Seiten 290–292», positiv arbeitende Photoresists auf der Basis von Chinondiaziden und Phenolharzen vom Novolak-Typ, gelöst in einem gebräuchlichen organischen Lösemittel. Daß das Lösemittel Propylenglykolalkyletheracetat enthält und in diesem Fall vor dem Belichten der Schicht bis zu einem bestimmten Restgehalt vorgetrocknet werden muß, damit die Schicht nicht mehr klebrig ist, ist diesem Dokument nicht zu entnehmen.

T. Batchelder und J. Piatt befassen sich in «Solid State Technics», Vol. 26, No. 8, Seiten 211–217, mit der Behandlung von Photoresists im allgemeinen durch Erwärmen vor und nach dem Belichten. Durch das «soft baking», der Wärmebehandlung vor dem bildmäßigen Belichten, soll der Anteil an Lösemitteln im Resist stabilisiert werden und eine reproduzierbare Resistschichtdicke gewährleistet werden (Seite 212, rechte Spalte unten, sowie Seite 213, linke Spalte unten und rechte Spalte).

J. E. Hamlin befaßt sich in «Paint and Resin», Band 53, 1983, Seiten 42–47, mit neuen Propylenglycolethern und -acetaten für Beschichtungslösungen. Es werden jedoch keine Angaben gemacht, daß diese Verbindungen auch als Lösemittel in positiv arbeitenden lichtempfindlichen Gemischen anwendbar sind.

Aus EP-A 0 164 620 ist eine positiv-arbeitende strahlungsempfindliche Beschichtungslösung bekannt, die als wesentliche Bestandteile mindestens ein polymeres Bindemittel, eine strahlungsempfindliche Verbindung und Propylenglykolalkyletheracetat enthaltendes Lösemittel enthält. Hieraus geht aber nicht hervor, wie ein hiermit hergestellter Photoresist beschaffen sein muß, um optimale Bedingungen zu erfüllen.

Es war Aufgabe der vorliegenden Erfindung ein Verfahren zur Herstellung eines verbesserten positiv arbeitenden Photoresistgemischs anzugeben, das zu Materialien mit wesentlich erhöhter Lichtempfindlichkeit führt und die in bezug auf die Erosionsrate des Photoresists, auf die Plasmaätzrate und auf den Kontrast unverändert oder gar verbessert ist.

Die Lösung der Aufgabe geht aus von einem Verfahren zur Herstellung eines Photoresists der eingangs beschriebenen Art und sie ist dadurch gekennzeichnet, daß das Lösungsmittel für das strahlungsempfindliche Gemisch Propylenglykolalkyletheracetat enthält oder daraus besteht und daß man das Vortrocknen bei Temperaturen im Bereich von etwa 20 bis 110°C so durchführt, daß die Schicht sich nicht mehr klebrig anfühlt, sie aber noch einen Restlösemittelanteil in einer Menge von etwa 1 bis 30, vorzugsweise 5 bis 20 Gewichtsprozent, bezogen auf die nichtflüchtigen Bestandteile der Schicht, enthält, und daß man als strahlungsempfindliche Verbindung ein Kondensationsprodukt aus einem Chinondiazidsulfonsäurechlorid und einer phenolischen Hydroxy- oder Polyhydroxy-Verbindung, einem Arylamin oder einem Polyamin, vorzugsweise Propylenglykolmethyletheracetat eingesetzt.

Es wurde gefunden, daß die Propylenglykolalkyletheracetat-Komponente, die auch als Lösemittel für das Harz und die lichtempfindliche Verbindung wirkt, das Aufbringen des Resists auf den Schichtträger erleichtert und zur Verbesserung der Lichtempfindlichkeit wesentlich beiträgt. Die Verwendung dieser Komponente ist auch deshalb von großem Vorteil, weil sie gegenüber den bekannten üblichen Lösemitteln eine geringe Toxizität aufweist.

Das erfindungsgemäße Verfahren zur Herstellung eines Photoresists wird in der Weise durchgeführt, daß zunächst ein Gemisch aus mindestens einem Harz der Novolake und Polyvinylphenole und mindestens einer lichtempfindlichen o-Chinondiazidverbindung in einem ein Propylenglykolalkyletheracetat enthaltenden Lösemittelgemisch gebildet wird, das Gemisch auf einen geeigneten Schichtträger aufgetragen und getrocknet wird, sodaß eine im wesentlichen unklebrige Schicht mit einem Restlösemittelanteil von 1 bis 30 %, bezogen auf die nichtflüchtigen Bestandteile der Schicht, erhalten wird, die Schicht mittels geeigneter Strahlung bildmäßig belichtet wird und schließlich die belichteten Stellen mit einem wäßrig-alkalischen Entwickler entfernt werden. Der Restlösemittelanteil kann beispielsweise gravimetrisch oder durch IR-Messung der Carbonylgruppenabsorption des Lösemittels bestimmt werden.

In bevorzugter Ausführungsform des erfindungsgemäßen Verfahrens wird ein positiv-arbeitendes lichtempfindliches Gemisch verwendet, das ein Novolakharz, ein Chinondiazid als lichtempfindliche Verbindung und eine zur Erhöhung der Lichtempfindlichkeit des Gemischs ausreichende Menge eines Propylenglykolmethyletheracetats enthält.

Die erfindungsgemäßen Photoresistgemische weisen nicht nur eine erhöhte Lichtempfindlichkeit gegenüber bekannten positiv-arbeitenden Photoresists auf, sondern zeichnen sich auch durch einen hohen Auflösungsgrad, einen guten Entwicklungskontrast und gute Haftungseigenschaften aus. Mit diesen Eigenschaften unterscheiden sie sich deutlich von einigen bekannten Resists, die zwar eine mäßig gesteigerte Lichtempfindlichkeit besitzen, wobei diese Verbesserung allerdings auf Kosten von Auflösungsvermögen und Kontrast erzielt wird.

Die Produktion von Novolakharzen, die für die Herstellung von lichtempfindlichen Gemischen bevorzugt verwendet werden, ist bekannt. Ein Verfahren zur Herstellung dieser Novolake ist in "Chemistry and Application of Phenolic Resins" (Chemie und Anwendung von Phenolharzen), von A. Knop und W. Scheib, Springer Verlag, New York, 1979, Kapitel 4, beschrieben. Para- und Polyvinylphenole sind beispielsweise in US-A 3,869,292 und US-A 4,439,516 beschrieben. Dem Fachmann ist auch die Verwendung von o-Chinondiaziden bekannt, wie in "Light Sensitve Systems" von J. Kosar, John Wiley & Sons, New York, 1965, Kapitel 7.4, beschrieben. Diese lichtempfindlichen Verbindungen, die einen Bestandteil innerhalb des erfindungsgemäßen Verfahrens bilden, gehören zur Gruppe der substituierten lichtempfindlichen Naphthochinondiazide, wie sie üblicherweise in positiv-arbeitenden Photoresistansätzen verwendet werden. Solche Verbindungen sind zum Beispiel aus US-A 2,797,213, US-A 3,106,465, US-A 3,148,983, US-A 3,130,047, US-A 3,201,329, US-A 3,785,825 und US-A 3,802,885 bekannt. Geeignete lichtempfindliche Verbindungen sind zum Beispiel mit phenolischen Verbindungen, wie Hydroxybenzophenonen, kondensiertes 1,2-Naphthochinondiazid-5-sulfonylchlorid und 1,2-Naphthochinondiazid-4-sulfonylchlorid.

In bevorzugter Ausführung liegt der Gehalt an festen Bestandteilen des Photoresistgemischs, d.h. an Bindemittel und Diazid, vorzugsweise bei etwa 15 bis 99 Gewichtsprozent an Bindemittel und etwa 1 bis 85 Gewichtsprozent an Chinondiazid. Insbesondere ist das Bindemittel in einem Anteil von etwa 50 bis 90 Gewichtsprozent, und ganz besonders bevorzugt etwa 65 bis 85 Gewichtsprozent, bezogen auf das Gewicht der nichtflüchtigen Bestandteile der Schicht, in dem Gemisch enthalten. Der Anteil an strahlungsempfindlicher Verbindung liegt insbesondere bei etwa 10 bis 50 Gewichtsprozent und ganz besonders bevorzugt bei etwa 15 bis 35 Gewichtsprozent, bezogen auf das Gewicht der nichtflüchtigen Bestandteile der Schicht. Zur Herstellung des Photoresistgemisches werden das Harz und das Diazid so mit dem Propylenglykolalkyletheracetat gemischt, daß das Acetat in einem Anteil von etwa 40 bis 90 Gewichtsprozent, vorzugsweise von etwa 60 bis 83 Gewichtsprozent, und insbesondere von etwa 65 bis 70 Gewichtspro zent, jeweils bezogen auf das Gewicht des gesamten Resistgemischs, vorhanden ist.

Der Lösung aus Bindemittel, lichtempfindlicher Verbindung und Acetat können vor dem Aufbringen auf einen Schichtträger noch Zusätze, wie z.B. Farbmittel, Farbstoffe, Verlaufmittel, Weichmacher, Haftvermittler, Entwicklungsbeschleuniger, Lösemittel und Tenside, z.B. nicht-ionische Tenside, zugegeben werden.

Farbstoffe, die als Zusätze für die erfindungsgemäßen Photoresistgemische verwendet werden können, sind zum Beispiel Methylviolett 2B (C.I. 42 535), Kristallviolett (C.I. 42 555), Malachitgrün (C.I. 42 000), Victoriablau B (C.I. 44 045) und Neutralrot (C.I. 50 040). Diese Farbstoffe werden in einer Menge von 1 bis 10 Gewichtsprozent, bezogen auf das gemeinsame Gewicht von Harz und lichtempfindlicher Verbindung, zugesetzt. Die Farbstoffzusätze verringern die Rückstreuung von Licht vom Träger und tragen so zu einer verbesserten Auflösung bei.

Verlaufmittel können in einer Menge bis zu 5 Gewichtsprozent, bezogen auf das Gesamtgewicht von Bindemittel und lichtempfindlicher Verbindung, eingesetzt werden.

Geeignete Weichmacher sind zum Beispiel Phosphorsäuretri-(β-chlorethyl)-ester, Stearinsäure, Dicampher, Polypropylen, Acetalharze, Phenoxyharze und Alkydharze, die in Anteilen von 1 bis 10 Gewichtsprozent, bezogen auf das Gesamtgewicht von Bindemittel und lichtempfindlicher Ver bindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler sind zum Beispiel β-(3,4-Epoxycyclohexyl)-ethyltrimethoxysilan, p-Methyldisilanmethylmethacrylat, Vinyltrichlorsilan und -Aminopropyltriethoxysilan in einem Anteil bis zu 4 Gewichtsprozent, bezogen auf das Gesamtgewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das Gesamtgewicht von Bindemittel und lichtempfindlicher Verbindung, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen Anwendungen eingesetzt, bei denen es in erster Linie auf die Entwicklungsgeschwindigkeit ankommt, auch wenn dabei evtl. ein gewisser Grad an Kontrast geopfert wird; denn während die belichteten Bereiche der Photoresistschicht durch den Zusatz von Beschleunigern vom Entwickler schneller gelöst werden, bewirken die Entwicklungsbeschleuniger gleichzeitig auch einen größeren Verlust an Photoresistschicht aus den unbelichteten Bereichen.

Geeignete Lösemittel sind zum Beispiel Xylol, Butylaceat und Ethylenglykolmonomethyletheracetat, die in einem Anteil bis zu 95 Gewichtsprozent in dem gesamten Gemisch anwesend sein können; vorzugsweise werden jedoch in dem Gemisch keine zusätzlichen Lösemittel verwendet. Demnach beträgt der Anteil an Propylenglykolalkyletheracetat am Gesamtlösemittelgehalt des Gemisches vorzugsweise 5 bis 100 Prozent. Insbesondere beträgt der Anteil des Propylenglykolalkyletheracetats mindestens 50 Gewichtsprozent, bezogen auf das Gesamtgewicht des Lösemittels.

Als nicht-ionische Tenside können zum Beispiel Nonylphenoxy-poly(ethylenoxy)-ethanol, Octylphenoxy(ethylenoxy)-ethanol, und Dinonylphenoxy-poly(ethylenoxy)ethanol in einem Anteil bis zu 10 Gewichtsprozent, bezogen auf das gemeinsame Gewicht von Harz und lichtempfindlicher Verbindung, verwendet werden.

Die fertige Beschichtungslösung kann nach einem der in der Photoresisttechnik üblichen Verfahren, wie Tauchen, Sprühen und Aufschleudern, auf einen Schichtträger aufgebracht werden. Für das Aufschleudern kann zum Beispiel der Prozentanteil an Feststoffen in der Lösung so eingestellt werden, daß sich in Abhängigkeit von der im Einzelfall verwendeten Aufschleudergeschwindigkeit und der für den Aufschleudervorgang angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Die nach dem beschriebenen Verfahren hergestellten Beschichtungslösungen eignen sich insbesondere zum Auftragen auf Silicium-Wafer, die eine Schicht aus thermisch gezüchtetem Siliciumdioxid tragen, wie sie bei der Herstellung von Mikroprozessoren und anderen in der Mikroelektronik verwendeten Halbleiterbauelementen verwendet werden. Ebenso kann auch ein Wafer aus Aluminium mit einer Aluminiumoxidschicht eingesetzt werden. Der Träger kann auch aus verschiedenen polymeren Harzen, insbesondere aus transparenten Polymeren, wie zum Beispiel Polyestern, bestehen.

Nach dem Auftragen der Beschichtungslösung wird das Ganze einer Vortrocknung bei etwa 20 bis 110 °C unterworfen. Diese Wärmebehandlung erfolgt, um die Restlösemittelkonzentration im Photoresist zu verringern und zu steuern, ohne daß es dabei zu einer merklichen thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel praktisch vollständig verdampft sind und eine dünne Schicht aus Photoresistgemisch, deren Dicke etwa 1 µm beträgt, auf dem Schichtträger zurückbleibt. Bevorzugt liegt die Temperatur bei dieser Behandlung zwischen etwa 50 und 105°C, insbesondere zwischen etwa 80 und 105°C. Dieser Behandlungsschritt ist dann beendet, wenn sich der Lösemittelanteil nicht mehr nennenswert verringert. Die Wahl der jeweiligen Temperatur und Zeitdauer hängt von den vom Anwender gewünschten Resisteigenschaften, der verwendeten Ausrüstung und den ökonomisch erwünschten Beschichtungszeiten ab. Bei einer Behandlung mit Hilfe von Heizplatten, sogenannten "Hot Plates", ist eine Dauer von bis zu 3 Minuten, bevorzugt bis zu 1 Minute, wirtschaftlich sinnvoll. Beispielsweise kann die Vortrocknung innerhalb von 30 Sekunden bei 90 °C durchgeführt werden. In einem Umluftschrank beträgt die Dauer des Verdunstungsvorgangs zwischen 15 Minuten und 60 Minuten oder mehr. Die aufgebrachte Schicht verliert während der Vortrocknung ihre Klebrigkeit, und ihr Restlösemittelgehalt wird während dieses Behandlungsschritts erfindungsgemäß auf 1 bis 30 Gewichtsprozent, bevorzugt auf 5 bis 20 Gewichtsprozent, insbesondere auf 8 bis 12 Gewichtsprozent, jeweils bezogen auf das Trockengewicht der Schicht eingestellt.

Der beschichtete Träger wird anschließend in bekannter Weise mittels aktinischer Strahlung, insbesondere UV-Strahlung, durch geeignete Masken, Negative, Schablonen, usw. bildmäßig belichtet.

Als nächstes werden die mit dem Gemisch beschichteten und belichteten Schichtträger in eine wäßrig-alkalische Entwicklerlösung getaucht. Die Lösung wird vorzugsweise stark bewegt, was zum Beispiel durch Durchblasen von Stickstoff erfolgen kann. Als Entwickler sind beispielsweise wäßrig-alkalische Alkali-, Ammonium-oder Tetramethylammoniumhydroxidlösungen geeignet, doch kann auch jeder andere bekannte geeignete Entwickler verwendet werden. Die Träger bleiben im Entwicklerbad, bis die Schicht an den belichteten Stellen ganz oder wenigstens fast ganz abgelöst ist.

Nach dem Herausnehmen der beschichteten Wafer aus der Entwicklerlösung kann ein Nacherwärmen bzw. eine Einbrennbehandlung durchgeführt werden, um die Haftung und die chemische Beständigkeit der Schicht gegen Ätzlösungen und andere Substanzen zu erhöhen. Diese Wärmebehandlung nach dem Entwickeln kann aus einer Ofenhärtung von Schicht und Träger unterhalb des Erweichungspunktes der Schicht bestehen. Sie wird beispielsweise bei Temperaturen von 95 bis 160 °C, bevorzugt von 95 bis 150 °C, insbesondere von 112 bis 120 °C, durchgeführt. Das Nacherwärmen kann ebenfalls mit einem Heizplattensystem durchgeführt werden; die Dauer liegt dann zwischen etwa 10 Sekunden und der für die Vernetzung des Bindemittels nötigen Zeitspanne. In der Regel sind dies etwa 10 bis 90 Sekunden, bevorzugt etwa 30 bis 90 Sekunden, insbesondere 15 bis 45 Sekunden. Die Behandlung kann die Dauer von 90 Sekunden auch überschreiten, doch führt dies im allgemeinen nicht zu einer weiteren Verbesserung des Ergebnisses. Im Trockenschrank dauert dieser Behandlungsschritt länger. Die benötigte Zeit hängt von der jeweiligen genauen Schichtzusammensetzung und dem verwendeten Trägermaterial ab.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure oder mit Gasplasma behandelt werden. Die erfindungsgemäßen Photoresistgemische sind gegen derartige Ätzlösungen auf Säurebasis und gegen Plasmaätzen resistent und gewährleisten einen wirksamen Schutz der unbelichteten, mit dem Photoresistgemisch beschichteten Stellen des Sohichtträgers.

In den folgenden Beispielen werden die Verfahren zur Herstellung und Anwendung von erfindungsgemäßen Gemischen eingehend erläutert. Diese Beispiele sollen jedoch die Erfindung in keiner Weise in ihrem Umfang beschränken, und sie sollen nicht dahingehend ausgelegt werden, daß sie Bedingugnen, Parameter oder andere Werte angeben, die zur praktischen Ausführung der Erfindung ausschließlich anzuwenden sind.

Beispiel 1

Zwei Photoresistlösungen werden wie folgt hergestellt:

| Resist A | | Resist B | |
|---|---|---|---|
| Novolakharz | 23,8% | Novolakharz | 23,8% |
| photoaktive Komponente (Menge A) | 7,0% | photoaktive Komponente (Menge A) | 7,0% |
| Vergleichslösemittelgemisch aus 10% Xylol, 10% Butylacetat und 80% Ethylenglykolmonomethyletheracetat | 69,2% | Propylenglykol-methyletheracetat | 69,2% |

Die photoaktive Komponente ist das Kondensationsprodukt aus 1,2-Naphthochinondiazid-(2)-5-sulfonylchlorid und Trihydroxybenzophenon. Das Absorptionsvermögen von Resist A beträgt 1,31 und das von Resist B 1,33, wodurch sich bestätigt, daß sich das Niveau der photoaktiven Komponente in beiden Fällen entspricht. In beiden Fällen sind Novolakharz und photoaktive Komponente die gleichen. Das Harz wird in dem Lösemittel gelöst, wobei über Nacht gerührt wird, anschließend wird die photoaktive Komponente gelöst und die Lösung durch 0,2 m- Millipore Teflonfilter filtriert.

Beurteilung der Lichtempfindlichkeit

Die Beschichtungslösung wird mit einer festgelegten konstanten Schleudergeschwindigkeit auf mehrere Wafer aufgeschleudert. Dann werden die Wafer 30 Minuten im Umluftschrank bei 90 °C vorgetrocknet.Die anfänglichen Schichtdicken des aufgebrachten Photoresists werden mit einem Rudolf-Schichtdickenmeßgerät gemessen. Zur Messung der Lichtempfindlichkeit wird eine Kontrastkurve aufgestellt, wie in "Introduction to Microlithography" von G. C. Willson, Kapitel 3, S. 105, American Chemical Society, Washington, D.C., 1983, beschrieben. Dazu wird der Schichtdickenverlust nach einminütigem Entwickeln gegenüber dem Logarithmus der UV-Belichtungsdosis aufgetragen. Die Schichtdicke wird mit der beschriebenen Technik durch Laser-Interferometrie gemessen. Der Photoresist ßend mit AZ-Entwickler, hergestellt von American Hoechst Corporation, Somerville, New Jersey, USA, der mit entionisiertem Wasser im Verhältnis 1:1 verdünnt wurde bei 25 ± 5 °C entwickelt. Durch Extrapolation der Kurve auf den gesamten Schichtdickenverlust erhält man den Lichtempfindlichkeitswert (mJ/cm²), und die Steigung dieser Kurve gibt den Kontrast an. Für die Resists A und B werden die folgenden Ergebnisse erhalten:

| | Resist A | Resist B |
|---|---|---|
| Lichtempfindlichkeit (mJ/cm²) | 111,6 | 97,2 |
| Kontrast | 1,52 | 1,54 |
| anfängliche Schichtdicke | 1,811 | 1,797 |

Die Ergebnisse zeigen, daß bei Resist B die Lichtempfindlichkeit in einem vergleichbare Schichtdicken ergebenden Ansatz um 15 % verbessert ist. Es zeigt sich kein spürbarer Kontrastverlust.

Schichtabtrag

Der Dickenverlust der Photoresistschicht in den unbelichteten Bereichen nach dem Entwickeln (Schichtabtrag) soll niedrig gehalten werden, um die Flankensteilheit zu erhalten. Je geringer der Schichtabtrag ist, desto geringer ist die für die Belichtung erforderliche Lichtmenge. Der Schichtabtrag wird gemessen, indem eine unbelichtete, vorgetrocknete (90 °C während 30 min) Photoresistschicht über einen Zeitraum von 10 min in dem mit entionisiertem Wasser im Verhältnis 1:1 verdünnten Entwickler entwickelt und anschließend der Schichtdickenverlust pro Minute berechnet wird. Die Ergebnisse für die Photoresists A und B sind wie folgt:

|  | Resist A | Resist B |
|---|---|---|
| Schichtabtrag (Å/min) | 17 | 10 |

Der Schichtabtrag von Resist B ist mit dem von Resist A mindestens vergleichbar.

Bestimmung des Restlösemittelgehalts für Photoresist B

Die Vortrocknung wurde im Anschluß an die Schleuderbeschichtung in einem Umlufttrockenschrank bei einer Temperatur von 90 °C durchgeführt.

| Behandlungsdauer (Minuten) | Restlösemittelgehalt (%) |
|---|---|
| 0 | 34 |
| 2 | 19 |
| 5 | 14 |
| 8 | 13 |
| 13 | 11 |
| 23 | 10 |
| 48 | 8 |
| 78 | 8 |

Beispiel 2

Es wird nach den Angaben von Beispiel 1 gearbeitet, mit dem Unterschied, daß eine andere Menge (Menge B) der gleichen photoaktiven Komponente eingesetzt wird.

| Resist C | | Resist D | |
|---|---|---|---|
| Novolakharz | 23,3% | Novolakharz | 23,3% |
| photoaktive Komponente (Menge B) | 6,9% | photoaktive Komponente (Menge B) | 6,9% |
| Vergleichslösemittelgemisch aus 10% Xylol, 10% Butylacetat und 80% Ethylenglykolmonomethyl-etheracetat | 69,8% | Propylenglykol-methyletheracetat | 69,8% |

Die Vortrockunungsdauer der Wafer nach dem Aufschleudern der Photoresists wird variiert, und Lichtempfindlichkeit und Kontrast werden gemessen, wie in Beispiel 1 angegeben.

| Vortrocknungs-dauer 90°C (Minuten) | Resist C | | Resist D | |
|---|---|---|---|---|
| | Lichtempfindlichkeit (mJ/cm$^2$) | Kontrast | Lichtempfindlichkeit (mJ/cm$^2$) | Kontrast |
| 10 | 92 | 1,72 | 84 | 1,74 |
| 25 | — | — | 92 | 1,63 |
| 30 | 103 | 1,66 | 93 | 1,64 |
| 30 | 103 | 1,59 | 89 | 1,65 |

Die Lichtempfindlichkeit von Photoresist D ist in den angegebenen Fällen 9 bis 16 % verbessert.

EP 0 226 741 B1

Flammpunkte der Photoresists

Aus Sicherheitsgründen ist ein höherer Flammpunkt eine wünschenswerte Eigenschaft. Die Flammpunkte der Photoresists C und D wurden in einem Test nach ASTM (D93, Methode A) verglichen.

|  | Flammpunkt |
|---|---|
| Resist C | 42°C |
| Resist D | 48°C |

Der Resist D ist in bezug auf den Flammpunkt erheblich verbessert.

Plasmaätzrate

Die Plasmaätzrate einer Resistschicht soll zum trockenen Verarbeiten so niedrig wie möglich gehalten werden. Um diese zu testen, werden mit Photoresist beschichtete Proben einer starken Schichthärtung durch Nacherhitzen bei 140 °C während 30 Minuten unterzogen. Nachfolgend sind die Plasmaätzraten der Resists C und D angegeben. Die Testbedingungen in dem verwendeten Plasmaätzgerät sind wie folgt:
Leistung: 150 W
Druck: 0,6 Torr
Verhältnis $CF_4/O_2$: 95/5
$O_2$-Durchflußgeschwindigkeit: 60 Scm³ (Standardkubikzentimeter).

|  | Ätzrate (Å/min) |
|---|---|
| Resist C | 334 |
| Resist D | 313 |

Die Plasmaätzrate des Resists D ist mit der des Resists C mindestens vergleichbar.

Eindringtiefentest(DOP-Test)

Der Eindringtiefentest, beschrieben von D. J. Elliot in "Integrated Circuit Fabrication Technology", Kapitel 13, S. 325, McGraw Hill Book Company, New York (1982) gibt ebenfalls ein Maß für die Lichtempfindlichkeit eines positiv-arbeitenden Photoresists. In diesem Test wird die Photoresistschichtdicke gemessen, die bei einer bestimmten UV-Lichtmenge nach dem Entwickeln entfernt worden ist. Je größer die Schichtdicke ist, die entfernt wird, desto größer ist die Lichtempfindlichkeit. Es folgen die Ergebnisse, die beim Entwickeln mit dem in Beispiel 1 genannten Entwickler, verdünnt mit entionisiertem Wasser im Verhältnis 1:1, erhalten werden.

| Lichtmenge ($mJ/cm^2$) | Resist A ($\mu$m) | Resist B ($\mu$m) |
|---|---|---|
| 15,0 | 0,45 | 0,53 |
| 22,0 | 0,75 | 0,80 |
| 26,0 | 0,95 | 1,07 |
| 31,0 | 0,10 | 1,44 |
| 36,5 | 1,35 | 1,58 |

Aus diesem Test ergibt sich, daß der Resist B eine größere Lichtempfindlichkeit hat.

Die Abhängigkeit der Schichtdicke von der Schleudergeschwindigkeit (Aufschleuderkurven)

Aufschleuderkurven dienen dazu, aufgrund der Aufschleudergeschwindigkeit die Dicke der vorgetrockneten Photoresistschicht im voraus festzusetzen. Diese Kurven müssen daher regelmäßig sein und eine gerade Linie bilden, wenn sie in logarithmischen Maßstäben als Schichtdicke gegenüber der Aufschleudergeschwindigkeit aufgetragen werden. Die beiden Photoresists C und D werden jeweils mit verschiedenen Geschwindigkeiten, wie unten angegeben, aufgeschleudert, während 30 Minten bei 90 °C erwärmt und die Photoresistschichtdicke gemessen.

8

| U/min | Resist C (μm) | Resist D (μm) |
|-------|---------------|---------------|
| 2.000 | 2,47 | 2,79 |
| 3.000 | 1,99 | 2,28 |
| 4.000 | 1,77 | 1,95 |
| 5.000 | 1,51 | 1,74 |
| 6.000 | 1,38 | 1,60 |
| 7.000 | 1,28 | 1,47 |

Wird das Kurvenbild wie angegeben aufgetragen, so ergeben gibt sich beide Resists geradlinige Kurven hoher Korrelation. Da Resist D eine höhere Viskosität hat als Resist C (29,6 cSt gegenüber 37,8 cSt), sind die beiden Kurven gegeneinander versetzt. Jeder Photoresist ergibt jedoch eine "ordnungsgemäße" Aufschleuderkurve, wie man sie zur Vorausbestimmung der Schichtdicken benötigt.

Beispiel 3

Es wird nach dem Verfahren von Beispiel 1 gearbeitet, mit dem Unterschied, daß für Resist B ein Lösemittelgemisch verwendet wird.

| Resist A | | Resist B | |
|----------|---|----------|---|
| Novolakharz | 23,8% | Novolakharz | 23,8% |
| photoaktive Komponente | 7,0% | photoaktive Komponente | 7,0% |
| Vergleichslösemittelgemisch aus 10% Xylol, 10% Butylacetat und 80% Ethylenglykolmonomethyletheracetat | 69,2% | Lösemittelgemisch aus 10% Xylol, 10% Butylacetat und 80% Propylenglykolmethyletheracetat | 69,2% |

| | Resist A | Resist B |
|---|----------|----------|
| Lichtempfindlichkeit (mJ/cm$^2$) | 111,6 | 98,2 |
| Kontrast | 1,52 | 1,54 |
| anfängliche Schichtdicke | 1,811 | 2,170 |

Die Ergebnisse zeigen, daß Resist B eine Verbesserung der Lichtempfindlichkeit um 12 % ergibt, selbst wenn das Propylenglykolmethyletheracetat in Verbindung mit anderen Lösemitteln eingesetzt wird. Das ist insbesondere deshalb überraschend, weil Resist B eine erheblich größere Schichtdicke aufweist.

Beispiel 4

Es wird nach dem Verfahren von Beispiel 1 gearbeitet, mit dem Unterschied, daß zusätzlich ein Weichmacher verwendet wird.

| Resist A | | Resist B | |
|----------|---|----------|---|
| Polymethylvinylether | 15,43% | Polymethylvinylether | 15,43% |
| Novolakharz | 20,12% | Novolakharz | 20,12% |
| photoaktive Komponente | 5,96% | photoaktive Komponente | 5,96% |
| Vergleichslösemittelgemisch aus 10% Xylol, 10% Butylacetat und 80% Ethylenglykolmonomethyletheracetat | 58,5% | Propylenglykolmethyletheracetat | 58,5% |

|  | Resist A | Resist B |
|---|---|---|
| anfängliche Schichtdicke | 6,05 μm | 6,74 μm |
| Lichtempfindlichkeit (mJ/cm$^2$) | 114,85 | 100,0 |

Die Ergebnisse zeigen, daß in vergleichbaren Ansätzen mit einem Gehalt an Weichmacher (Polymethylvinylether) Resist B eine um 14,85 % verbesserte Lichtempfindlichkeit ergibt.

**Patentansprüche**

1. Verfahren zur Herstellung eines Photoresists durch Beschichten eines Schichtträgers mit einer strahlungsempfindlichen Beschichtungslösung aus mindestens einem wasserunlöslichen, in wäßrig-alkalischen Lösungen löslichen Bindemittel und mindestens einer strahlungsempfindlichen Verbindung, wie o-Chinondiazid, in einem Lösungsmittel, Vortrocknen der Beschichtungslösung bei erhöhter Temperatur, bildmäßiges Belichten der gebildeten Schicht mit aktinischer Strahlung, Entwickeln durch Weglösen der belichteten Bereiche mit einem wäßrig-alkalischen Entwickler und Nacherwärmen zwecks Verfestigung der Bildschicht, dadurch gekennzeichnet, daß das Lösungsmittel für die strahlungsempfindliche Verbindung Propylenglykolalkyletheracetat enthält oder daraus besteht und daß man das Vortrocknen im Bereich von etwa 20 bis 110°C so durchführt, daß die Schicht sich nicht mehr klebrig anfühlt, sie aber noch einen Restlösemittelanteil in einer Menge von etwa 1 bis 30 Gewichtsprozent, bezogen auf die nichtflüchtigen Bestandteile der Schicht, enthält und daß man als strahlungsempfindliche Verbindung ein Kondensationsprodukt aus einem Chinondiazidsulfonsäurechlorid und einer phenolischen Hydroxy- oder Polyhydroxy-Verbindung, einem Arylamin oder einem Polyamin einsetzt.

2. Verfahren nach Anspruch 1, dadurch gekennzeichnet, daß man das Vortrocknen so durchführt, daß die Schicht noch einen Restlösemittelanteil von etwa 5 bis 20 Gewichtsprozent, bezogen auf die nichtflüchtigen Bestandteile der Schicht, enthält.

3. Verfahren nach Anspruch 1, dadurch gekennzeichnet, daß man als Glykoletherester Propylenglykolmethyletheracetat verwendet.

4. Verfahren nach Anspruch 1 oder 2, dadurch gekennzeichnet, daß man das Propylenglykolalkyletheracetat in der Beschichtungslösung in einer Menge von mindestens 50 Gewichtsprozent, bezogen auf das Gesamtgewicht des Lösemittels, verwendet.

5. Verfahren nach Anspruch 1, dadurch gekennzeichnet, daß man das Bindemittel in der Beschichtungslösung in einer Menge von etwa 65 bis 85 Gewichtsprozent, bezogen auf die nichtflüchtigen Bestandteile der Schicht, einsetzt.

6. Verfahren nach Anspruch 1, dadurch gekennzeichnet, daß man die strahlungsempfindliche Verbindung in einer Menge von etwa 15 bis 35 Gewichtsprozent, bezogen auf die nichtflüchtigen Bestandteile der Schicht, einsetzt.

7. Verfahren nach Anspruch 6, dadurch gekennzeichnet, daß man ein Kondensationsprodukt aus 1,2-Naphthochinondiazid-(2)-5-sulfonylchlorid und Trihydroxybenzophenon einsetzt.

8. Verfahren nach Anspruch 1 oder 5, dadurch gekennzeichnet, daß man als Bindemittel ein Novolakharz einsetzt.

9. Verfahren nach Anspruch 1, dadurch gekennzeichnet, daß man als Schichtträger Unterlagen aus Silicium, Aluminium, polymeren Harzen, Siliciumdioxid, dotiertes Siliciumdioxid, Siliciumnitrid, Tantal, Kupfer, polykristallines Silicium, Keramik oder Aluminium/Kupfer-Legierungen verwendet.

**Claims**

1. Process for the production of a photoresist by coating a coating substrate with a radiation-sensitive coating solution comprising at least one binder which is insoluble in water, but soluble in aqueous-alkaline solutions, and at least one radiation-sensitive compound, such as diazo-o-quninone, in a solvent, pre-drying the coating solution at elevated temperature, exposing the coating formed image-wise with actinic radiation, developing the coating by dissolving away the exposed areas using an aqueous-alkaline developer, and subsequently warming the material in order to harden the image coating, characterized in that the solvent for the radiation-sensitive compound contains or comprises propylene glycol alkyl ether acetate and in that the pre-drying is carried out in the range from about 20 to 110°C in a manner such that the coating no longer feels tacky, but still contains residual solvent in an amount of from about 1 to 30 per cent by weight, based on the non-volatile components of the coating, and in that the radiation-sensitive compound employed is a product of the condensation of a diazoquinonesulphonyl chloride and a phenolic hydroxyl or polyhydroxyl compound, an arylamine or a polyamine.

2. Process according to Claim 1, characterized in that the pre-drying is carried out in a manner such that the coating still contains residual solvent in an amount from about 5 to 20 per cent by weight, based on the nonvolatile components of the coating.

3. Process according to Claim 1, characterized in that the glycol ether ester used is propylene glycol methyl ether acetate.

4. Process according to Claim 1 or 2, characterized in that the propylene glycol alkyl ether acetate is used in the coating solution in an amount of at least 50 per cent by weight, based on the total weight of the solvent.

5. Process according to Claim 1, characterized in that the binder is employed in the coating solution in an amount of from about 65 to 85 per cent by weight, based on the non-volatile components of the coating.

6. Process according to Claim 1, characterized in that the radiation-sensitive compound is employed in an amount of from about 15 to 35 per cent by weight, based on the non-volatile components of the coating.

7. Process according to Claim 6, characterized in that a product of the condensation of 2-diazo-1,2-naphthoquinone-5-sulphonyl chloride and trihydroxybenzophenone is employed.

8. Process according to Claim 1 or 5, characterized in that the binder employed is a novolak resin.

9. Process according to Claim 1, characterized in that the coating substrate used is a substrate comprising silicon, aluminium, polymeric resins, silicon dioxide, doped silicon dioxide, silicon nitride, tantalum, copper, polycrystalline silicon, ceramic or aluminium/copper alloys.

**Revendications**

1. Procédé de préparation d'un matériau photorésistant par enduction d'un substrat avec une solution d'enduction sensible au rayonnement et constituée par au moins un liant insoluble à l'eau et soluble dans des solutions alcalines aqueuses et par au moins un composé sensible au rayonnement, comme par exemple du o-quinonediazide, dans un solvant, séchage préalable de la solution d'enduction à température élevée, exposition, conformément à une image, de la couche formée, à un rayonnement actinique, développement par élimination des zones exposées à l'aide d'un révélateur alcalin aqueux et chauffage ultérieur en vue de réaliser un renforcement de la couche d'image, caractérisé en ce que le solvant prévu pour le composé sensible au rayonnement contient de l'acétate de propylèneglycolalkyléther ou est constitué à partir de ce dernier et qu'on exécute le séchage préalable dans une gamme de températures comprise entre environ 20 et 110°C de manière que la couche ne soit plus collante, mais contienne encore un pourcentage résiduel de solvant en une quantité comprise entre environ 1 à 30 pour cent en poids, rapportés aux composants non volatils de la couche, et qu'on utilise, comme composé sensible au rayonnement, un produit de condensation obtenu à partir d'un chlorure de l'acide quinonediazidesulfonique et d'un composé hydroxy ou polyhydroxy phénolique, d'une arylamine ou d'une polyamine.

2. Procédé selon la revendication 1, caractérisé en ce qu'on exécute le séchage préalable de manière que la couche contienne encore un pourcentage résiduel de solvant compris entre environ 5 et 20 pour cent en poids, rapportés aux composants non volatils de la couche.

3. Procédé selon la revendication 1, caractérisé en ce qu'on utilise, comme ester de glycoléther, un acétate de propylèneglycolméthyléther.

4. Procédé selon la revendication 1 ou 2, , caractérisé en ce qu'on utilise l'acétate de propylèneglycolalkyléther dans la solution d'enduction, en une quantité égale à au moins 50 pour cent en poids, rapportés au poids total du solvant.

5. Procédé selon la revendication 1, caractérisé en ce qu'on introduit le liant dans la solution d'enduction en une quantité comprise entre environ 65 et 85 pour cent en poids, rapportés aux composants non volatils de la couche.

6. Procédé selon la revendication 1, caractérisé en ce qu'on introduit le composé sensible au rayonnement en une quantité comprise entre environ 15 et 35 pour cent en poids, rapportés aux composants non volatils de la couche.

7. Procédé selon la revendication 6, caractérisé en ce qu'on utilise un produit de condensation formé de chlorure de 1,2-naphtoquinone-diazide-(2)-5-sulfonyle et de trihydroxybenzophénone.

8. Procédé selon la revendication 1 ou 5, caractérisé en ce qu'on utilise comme liant une résine novolaque.

9. Procédé selon la revendication 1, caractérisé en ce qu'on utilise, comme substrat, des substrats constitués par du silicium, de l'aluminium, des résines polymériques, du bioxyde de silicium, du bioxyde de silicium dopé, du nitrure de silicium, du tantale, du cuivre, du silicium polycristallin, une céramique ou des alliages d'aluminium/cuivre.